(19) Europäisches Patentamt
European Patent Office
Office européen des brevets

(11) **EP 1 728 324 B1**

(12) **EUROPÄISCHE PATENTSCHRIFT**

(45) Veröffentlichungstag und Bekanntmachung des Hinweises auf die Patenterteilung:
**07.10.2009 Patentblatt 2009/41**

(21) Anmeldenummer: **05701649.5**

(22) Anmeldetag: **07.02.2005**

(51) Int Cl.:
***H03K 17/082*** *(2006.01)*

(86) Internationale Anmeldenummer:
**PCT/EP2005/050511**

(87) Internationale Veröffentlichungsnummer:
**WO 2005/091502 (29.09.2005 Gazette 2005/39)**

(54) **ANSTEUERSCHALTUNG ZUM ANSTEUERN EINER LEISTUNGSELEKTRONISCHEN SCHALTUNG SOWIE VERFAHREN HIERZU**

CONTROL CIRCUITRY FOR CONTROLLING A POWER ELECTRONIC CIRCUIT AND METHOD THEREFOR

CIRCUIT DE COMMANDE DESTINE A LA COMMANDE D'UN CIRCUIT ELECTRONIQUE DE PUISSANCE ET PROCEDE CORRESPONDANT

(84) Benannte Vertragsstaaten:
**DE FR GB IT SE**

(30) Priorität: **19.03.2004 DE 102004013599**

(43) Veröffentlichungstag der Anmeldung:
**06.12.2006 Patentblatt 2006/49**

(73) Patentinhaber: **ROBERT BOSCH GMBH**
**70442 Stuttgart (DE)**

(72) Erfinder:
• **KUEHNER, Jochen**
**71522 Backnang (DE)**
• **PLIKAT, Robert**
**29369 Ummern (DE)**
• **MUELLER, Stefan**
**70563 Stuttgart (DE)**
• **REES, Stephan**
**71636 Ludwigsburg (DE)**
• **RUF, Armin**
**70435 Stuttgart (DE)**

(56) Entgegenhaltungen:
**EP-A- 0 851 584         US-A- 5 475 329**
**US-A- 5 828 141         US-A- 6 046 516**
**US-B1- 6 285 235**

EP 1 728 324 B1

**Beschreibung**

Die Erfindung betrifft eine Ansteuerschaltung zum Ansteuern einer leistungselektronischen Schaltung. Die Erfindung betrifft weiterhin ein Verfahren zum Ansteuern einer leistungselektronischen Schaltung.

In leistungselektronischen Stellgliedern werden nahezu ausschließlich spannungsgesteuerte Halbleiterschalter, wie z. B. MOSFETs und IGBTs eingesetzt. Solche leistungselektronischen Stellglieder werden beispielsweise als Gleichstromsteller, Pulswechselrichter und dergleichen eingesetzt. Eine solche Schaltung weist in der Regel einen Strompfad auf, der eine Lastdrossel, eine Freilaufdiode und einen Halbleiterschalter, insbesondere in Form eines Feldeffekttransistors aufweist. Ferner besitzen die Leitungsverbindungen zwischen den Bauelementen Eigeninduktivitäten, die parasitär sind und das Schaltverhalten in dem Strompfad beeinflussen.

Um den Feldeffekttransistor von einem leitenden in einen sperrenden Zustand bzw. von einem sperrenden in einen leitenden Zustand zu überführen, muss dessen Gate-Source-Kapazität ent- bzw. aufgeladen werden. Für einen möglichst schnellen Übergang (übliche Umladezeiten betragen lediglich einige hundert Nanosekunden) ist daher ein vergleichsweise großer Umladestrom (etwa zwischen 0,5 und 4 A) erforderlich. Diese Umladeströme werden in der Regel von einer Treiberschaltung zur Verfügung gestellt. Insbesondere weist eine solche Treiberschaltung eine Spannungsquelle auf, die die Gate-Source-Kapazität über einen Widerstand auf- bzw. entlädt, wobei über den Widerstand die Höhe des Gate-Stroms verändert und somit die Schaltgeschwindigkeit des Leistungshalbleiters beeinflusst werden kann.

Es kann ferner eine Diodenschaltung mit einer Diode und einem Widerstand vorgesehen sein, die parallel zu dem Widerstand geschaltet ist, um ein schnelleres Entladen der Gate-Source-Kapazität bei einem Abschaltvorgang zu ermöglichen. Das Einstellen der Lade- bzw. Entladegeschwindigkeit der Gate-Source-Kapazität ist wesentlich, da bei einem abrupten Ausschalten des Feldeffekttransistors aufgrund der Induktivitäten im Strompfad die Spannung über Drain und Source des Feldeffekttransistors über die bereitgestellte Versorgungsspannung hinaus ansteigt. Da der Feldeffekttransistor nur eine bestimmte Spannungsfestigkeit besitzt, durch die eine maximale Drain-Source-Spannung vorgegeben ist, muss die Änderungsgeschwindigkeit des Lade- bzw. Entladestroms für die Gate-Source-Kapazität vorgegeben sein. Durch eine geringere Änderungsgeschwindigkeit der Gate-Kapazität können zwar unerwünschte Effekte, wie die Überspannung zwischen den Drain-und Source-Anschlüssen aufgrund der parasitären Induktivitäten, Störemissionen und Diodenrückströme reduziert werden, jedoch nehmen dann die Schaltverluste, d. h. die in dem Feldeffekttransistor in Wärme umgesetzte Leistung, erheblich zu. Durch das feste Einstellen der Lade- bzw. Entladegeschwindigkeit der Gate-Source-Kapazität kann lediglich ein Kompromiss zwischen Schaltverlusten einerseits und Überspannungen sowie Störemissionen andererseits erzielt werden.

Die US 5,828,141 beschreibt eine Vorrichtung zum Schalten einer induktiven Last mittels eines MOSFET-Schalters, wobei die während des Abschaltens über die Last abfallende Spannung begrenzt wird. Dabei werden zur schnellen Entmagnetisierung der Last in konstanter Entmagnetisierungszeit ein oder mehrere Blockierschaltungen mit unterschiedlichen, temperaturunabhängigen Blockierspannungen verwendet.

Die EP 0 851 584 A2 beschreibt eine Nebenschlussschaltung zum Schutz eines Leistungstransistors. Der Leistungstransistor kann zum Betreiben einer Last an einem Ausgang des Leistungstransistors verwendet werden. Ein Prüfwiderstand ist zwischen einem Spannungsversorgungsanschluss und dem Ausgang des Leistungstransistors angeordnet. Der Steueranschluss des Leistungstransistors ist mit einer strombegrenzten Steuerschaltung verbunden. Um zu verhindern, dass die über den Transistor abfallende Spannung einen festgelegten Maximalwert überschreitet, ist ein Kurzschlusstransistor zwischen dem Ausgang der Treiberschaltung und der Spannungsversorgung vorgesehen. Der Steueranschluss dieses Transistors ist mit dem Ausgang des Leistungstransistors derart verbunden, dass die über den Leistungstransistor abfallende Spannung auf einen Grenzwert begrenzt wird, der kleiner als die Spannung am Ausgang des Leistungstransistors ist.

Die US 6,046,516 beschreibt einen elektronischen Schalter zum Schalten induktiver Lasten. Der elektronische Schalter umfasst ein Schaltelement, das als FET betrieben wird und eine in Sperrrichtung betriebene interne Diode aufweist. Der elektronische Schalter umfasst weiter eine Steuerschaltung zum Ausführen von Steuerkommandos, die dafür ausgebildet ist, eine derartige Spannung an einem Steueranschluss des Schaltelements bereitzustellen, dass kein Strom durch die Diode fließt. Die Kontrollschaltung umfasst weiter eine Funktionseinheit, durch die das Schaltelement in Abhängigkeit einer Kommutierungsspannung oder eines Kommutierungsstromes in einen leitfähigen Zustand gebracht wird.

Die US 6,285,235 B1 beschreibt eine Steuerschaltung zum An-und Abschalten eines spannungsgesteuerten Schaltelements, beispielsweise eines MOSFET, eines IGBT oder eines IEGT. Das Schaltelement weist einen Steuer-, einen Emitter- und einen Kollektoranschluss auf. Eine erste Gleichspannungsquelle ist über einen ersten Schalter mit dem Steueranschluss verbunden, um eine positive Spannung an den Steueranschluss anzulegen und das Schaltelement anzuschalten, falls der erste Schalter geschlossen und der zweite Schalter geöffnet ist. Die Steuerschaltung umfasst weiter eine zweite Gleichspannungsquelle, die über den zweiten Schalter mit dem Steueranschluss des Schaltelements verbunden und dazu ausgebildet ist, eine negative Spannung an den Steueranschluss anzulegen, um das Schaltelement abzuschalten, falls der zweite Schalter geschlossen und der erste Schalter geöffnet ist. Die Steuerschaltung umfasst weiter eine Parallelschaltung einer Diode und eines Kondensators, die mit dem zweiten Schalter in Serie geschaltet ist. Die Steuerschaltung umfasst weiter eine Hilfsschaltung, die dazu ausgebildet ist, den Kondensator mit einer negativen Ladung zu beladen, um das Abschalten des Schaltelements zu unterstützen.

Die US 5,475,329 beschreibt eine Abschaltschaltung, die einen Entladepfad zwischen einem ersten und einem zweiten Knoten bereitstellt. Die Abschaltschaltung umfasst eine Abschaltvorrichtung mit einem ersten Strompfad, der mit einem ersten Knoten verbunden ist, einem zweiten Strompfad, der mit einem zweiten Knoten verbunden ist und einem Eingang. Eine Kontrollschaltung weist einen Ausgang, der mit dem Eingang der Abschaltschaltung verbunden ist, und einen Eingang auf. Eine Schutzvorrichtung weist einen Ausgang, der mit dem ersten Knoten verbunden ist, und einen Eingang auf. Gemeinsam bilden die Abschaltvorrichtung, die Kontrollschaltung und die Schutzvorrichtung die Abschaltschaltung. Ein erstes Kontrollsignal ist mit dem Eingang der Kontrollschaltung verbunden, ein zweites Kontrollsignal ist mit dem Eingang der Schutzvorrichtung verbunden.

Es ist daher Aufgabe der vorliegenden Erfindung eine Ansteuerschaltung sowie ein Ansteuerverfahren zur Verfügung zu stellen, womit ein besseres Schaltverhalten einer leistungselektronischen Schaltung ermöglicht wird.

Diese Aufgabe wird durch die Ansteuerschaltung nach Anspruch 1 sowie durch das Verfahren nach Anspruch 16 gelöst.

Weitere vorteilhafte Ausgestaltungen der Erfindung sind in den abhängigen Ansprüchen angegeben.

Gemäß einem ersten Aspekt der vorliegenden Erfindung ist eine Ansteuerschaltung zum Ansteuern einer leistungselektronischen Schaltung, die einen Strompfad durch einen Halbleiterschalter und durch eine Leitung aufweist, vorgesehen. Die Induktivität der Leitung und/oder eines Bauteils im Strompfad führt beim Schalten des Halbleiterschalters zu einer Überspannung zwischen einem ersten und einem zweiten stromführenden Anschluss des Halbleiterschalters. Die Ansteuerschaltung weist eine steuerbare Stromquelle, um einen ladungsgesteuerten Steueranschluss des Halbleiterschalters mit einem Steuerstrom zu laden bzw. zu entladen und eine Steuereinheit auf. Die Steuereinheit steuert die Stromquelle so an, dass bei einem Schaltvorgang die Anschlussspannung über den stromführenden Anschlüssen des Halbleiterschalters eine vorgegebene Soll-Anschlussspannung nicht übersteigt.

Die Idee der Erfindung besteht darin, die hohen Überspannungen zwischen den Anschlüssen eines Halbleiterschalters beim Ein- und Ausschaltvorgang zu reduzieren und zu regeln, die aufgrund von Induktivitäten in dem zu schaltenden Strompfad entstehen. Dies wird dadurch erreicht, dass an dem Steueranschluss des Halbleiterschalters ein geregeltes Steuerpotential angelegt wird, das abhängig von der Anschlussspannung an dem Halbleiterschalter eingestellt wird. Da der Halbleiterschalter in der Regel nur eine maximale Spannung zwischen dem stromführenden Anschlüssen übersteht, wird eine Soll-Anschlussspannung festgelegt, wobei das Steuerpotential so geregelt wird, dass die Soll-Anschlussspannung nicht überschritten wird. Dies ermöglicht es, die Kommutierungsspannung direkt vorzugeben, wodurch einerseits die Spannungsfestigkeit der eingesetzten Halbleiterschalter optimal ausgenutzt werden kann und andererseits die bei der Ansteuerung gemäß dem Stand der Technik im Betrieb auftretenden Schwingungen erheblich verringert werden können. Beim Regelvorgang wird der Halbleiterschalter durch die Regelung in seinem aktiven Betriebsbereich gehalten.

Mit der erfindungsgemäßen Ansteuerschaltung gelingt es, ohne zusätzliche Schutzbeschaltung die auftretenden Überspannungen zwischen den stromführenden Anschlüssen des Halbleiterschalters zu verringern und zu regeln und gleichzeitig die Erhöhung der Schaltverluste so gering wie möglich zu halten. Durch die verringerte Überspannung können die elektromagnetischen Störemissionen durch den Schaltvorgang reduziert werden, weil die angeregte Oszillation eine kleinere Anfangsamplitude aufweist und somit schneller abklingt. Dadurch lassen sich Filter und Schirmungsmaßnahmen weniger aufwendig und damit kostengünstiger gestalten.

Bei Leistungs-Feldeffekttransistoren nimmt der Einschaltwiderstand $R_{DS,on}$ überproportional mit der maximalen Sperrspannung zu, verhält sich jedoch umgekehrt proportional zur Chipfläche des Feldeffekttransistors. Die Begrenzung der Überspannung ermöglicht es, Feldeffekttransistoren mit kleinerer Durchbruchsspannung zu verwenden. Diese weisen bei gleicher Chip-Fläche einen niedrigeren Einschaltwiderstand auf, so dass der Wirkungsgrad der Leistungselektronik gesteigert werden kann. Werden andererseits Feldeffekttransistoren mit kleiner Chip-Fläche eingesetzt, die den gleichen Einschaltwiderstand $R_{DS,on}$ wie ein größerer Feldeffekttransistor besitzen, ergibt sich eine Verkleinerung des Bauraums.

Vorzugsweise hängt die Soll-Anschlussspannung von der maximal zulässigen Anschlussspannung zwischen dem stromführenden Anschlüssen des Halbleiterschalters ab. Die Soll-Anschlussspannung ist daher so gewählt, dass sie größer ist als die Versorgungsspannung der leistungselektronischen Schaltung, jedoch um einen bestimmten Sicherheitsbetrag unterhalb der maximal zulässigen Anschlussspannung liegt. Insbesondere kann ein relativer Sicherheitsbereich bezüglich der maximal zulässigen Anschlussspannung definiert werden.

Die Steuereinheit kann eine Vergleicherschaltung aufweisen, um die Anschlussspannung mit der Soll-Anschlussspannung zu vergleichen und die Stromquelle abhängig von dem Ergebnis des Vergleichens anzusteuern.

Die Steuereinheit kann einen P-Regler aufweisen, um die Stromquelle anzusteuern, so dass eine Änderung des Steuerstromes proportional zur Differenz zwischen der Anschlussspannung und der Soll-Anschlussspannung ist. Dies stellt eine möglichst einfache Realisierung einer Steuereinheit gemäß der erfindungsgemäßen Ansteuerschaltung dar.

Die Soll-Anschlussspannung kann bei einem Ausschaltvorgang größer sein als die an dem Strompfad angelegte Betriebsspannung. Insbesondere ist die Soll-Anschlussspannung so gewählt, dass sie größer ist als die Betriebsspannung, jedoch kleiner ist als die maximal zulässige Anschlussspannung des Halbleiterschalters.

Die Stromquelle kann so ausgelegt sein, dass der Steuereingang des Halbleiterschalters über die Stromquelle auf ein Potential aufladbar ist, das niedriger ist als das niedrigste Potential des Strompfades, das durch die Betriebsspannung vorgegeben ist. Auf diese Weise kann eine negative Gate-Source-Spannung erreicht werden, durch die insbesondere ein vollständiges Sperren bzw. vollständiges Durchschalten des Halbleiterschalters - je nach Leitfähigkeitstyp des Halbleiterschalters - erreicht werden kann.

Vorzugsweise stellt die Steuereinheit bei einem Einschaltvorgang die Soll-Anschlussspannung zunächst auf einen ersten Sollwert und nach Ablauf einer Zeitdauer auf einen zweiten Sollwert ein, wobei der zweite Sollwert kleiner oder gleich einem niedrigen Betriebspotential bei einem selbstsperrenden Halbleiterschalter bzw. größer oder gleich einem hohen Betriebspotential bei einem selbstleitenden Halbleiterschalter ist. Ein solcher zweistufiger Schaltvorgang ist sinnvoll, um die Überspannungen während des Einschaltvorgangs bestmöglich beeinflussen zu können. Dazu wird gemäß dem ersten Sollwert der Halbleiterschalter während der Zeitdauer vorzugsweise in seinem aktiven Betriebsbereich betrieben. Um die Durchlassverluste in dem Halbleiterschalter zu beschränken, muss nach Ablauf der Zeitdauer der zweite Sollwert als Soll-Anschlussspannung eingestellt werden um den Halbleiterschalter vollständig auf Durchlass zu schalten, so dass der Halbleiterschalter durch die hohen Durchlassverluste nicht zerstört wird. Würde zu Beginn des Einschaltvorgangs regelrecht der zweite Sollwert vorgegeben werden, d. h. der Einschaltvorgang nur durch Vorgabe einer Soll-Anschlussspannung, die - je nach Leitfähigkeitstyp des verwendeten Halbleiterschalters - kleiner oder gleich einem niedrigen Betriebspotential bzw. größer oder gleich einem hohen Betriebspotential ist, würde die Steuereinheit versuchen, den Halbleiterschalter schnellstmöglich vollständig einzuschalten. Dies hätte zur Folge, dass die Kommutierungsspannung an den Induktivitäten und damit auch die Änderungsgeschwindigkeit des Stromes im Strompfad sehr groß würden, so dass der Schaltvorgang nahezu einem Schaltvorgang gemäß dem Stand der Technik entsprechen würde und die Spannung zwischen den stromführenden Anschlüssen stark ansteigen würde. Durch den zweistufigen Regelungsvorgang kann die Änderungsgeschwindigkeit des Stromes im Strompfad verringert werden, so dass Störemissionen reduziert werden.

Vorzugsweise ist ein Verzögerungselement vorgesehen, um die Zeitdauer beginnend mit dem Einschaltvorgang fest vorzugeben, wobei die Zeitdauer mindestens der Zeit entspricht, nach der der Einschaltvorgang in jedem Fall abgeschlossen ist. Dies ist notwendig, um sicher zu verhindern, dass die Regelung noch während des Kommutierungsvorgangs versucht, den Halbleiterschalter vollständig einzuschalten.

Alternativ kann eine Zeitsteuereinheit vorgesehen sein, um die Soll-Anschlussspannung abhängig von einem Strom und/oder Spannungsverlauf in dem Strompfad einzustellen.

Insbesondere ist es möglich, im Falle, dass ein Feldeffekttransistors als Halbleiterschalter vorgesehen ist, dass die Zeitdauer durch einen Kommutierungsbeginn und eine maximale Kommutierungsdauer nach dem Beginn des Einschaltvorgangs bestimmt ist, wobei der Kommutierungsbeginn dadurch bestimmt ist, dass die Steigung der Gate-Source-Spannung zwischen dem Gate-Anschluss und dem Source-Anschluss erstmalig nach dem Beginn des Einschaltvorgangs 0 wird. Bei dieser Ausführungsform wird für die Detektion des Kommutierungsbeginns die Tatsache ausgenutzt, dass sich die Ableitung der Gate-Source-Spannung nach dem Beginn des Einschaltvorgangs erstmals dem Wert 0 nähert, wenn die Kommutierung einsetzt.

Alternativ kann der Kommutierungsbeginn dadurch bestimmt sein, dass die Drain-Source-Spannung ein Schwellpotential unterschreitet, wobei das Schwellpotential zwischen einem maximalen Betriebspotential und der ersten Sollspannung liegt.

Gemäß einer weiteren Alternative kann der Kommutierungsbeginn dadurch bestimmt sein, dass der Steuerstrom erstmals nach dem Beginn des Einschaltvorgangs einen Schwellwert unterschreitet, wobei der Schwellwert zwischen 0V und einem Steuerstrom-Sollwert liegt.

Gemäß einer weiteren Ausführungsform kann der Halbleiterschalter auch als IGBT-Bauelement ausgebildet sein.

Gemäß einem weiteren Aspekt der vorliegenden Erfindung ist ein Verfahren zum Ansteuern einer leistungselektronischen Schaltung vorgesehen. Die leistungselektronische Schaltung weist einen Strompfad durch einen ladungsgesteuerten Halbleiterschalter und einer Leitung auf, wobei die Induktivität der Leitung und/oder in dem Strompfad geschaltete elektrische Bauelemente beim Schalten des Halbleiterschalters zu einer Überspannung zwischen einem ersten und einem zweiten stromführenden Anschluss des Halbleiterschalters führt. Ein ladungsgesteuerter Steueranschluss des Halbleiterschalters wird mit einem Steuerstrom geladen bzw. entladen, wobei der Steuerstrom so gesteuert wird, dass bei einem Schaltvorgang die Anschlussspannung des Halbleiterschalters eine vorgegebene Soll-Anschlussspannung nicht übersteigt.

Bevorzugte Ausführungsformen der Erfindung werden im Folgenden anhand der beigefügten Zeichnungen näher erläutert. Es zeigen:

Figur 1 eine Ansteuerschaltung in einer leistungselektronischen Schaltung gemäß dem Stand der Technik;

Figur 2 ein Ersatzschaltbild einer vereinfachten Ansteuerschaltung gemäß dem Stand der Technik;

Figur 3 ein Blockschaltbild einer erfindungsgemäßen Ansteuerschaltung gemäß einer ersten Ausführungsform;

Figur 4 ein Diagramm zur Darstellung des Verlaufs der Soll-Anschlussspannung während eines Abschaltvorgangs;

Figur 5 eine Darstellung des Verlaufs der Soll-Anschlussspannung während eines Einschaltvorgangs; und

Figur 6 ein Blockschaltbild zur Generierung eines Umschaltsignals zum Bestimmen der Zeitdauer zum Umschalten zwischen dem ersten Sollwert und dem zweiten Sollwert bei einem Einschaltvorgang.

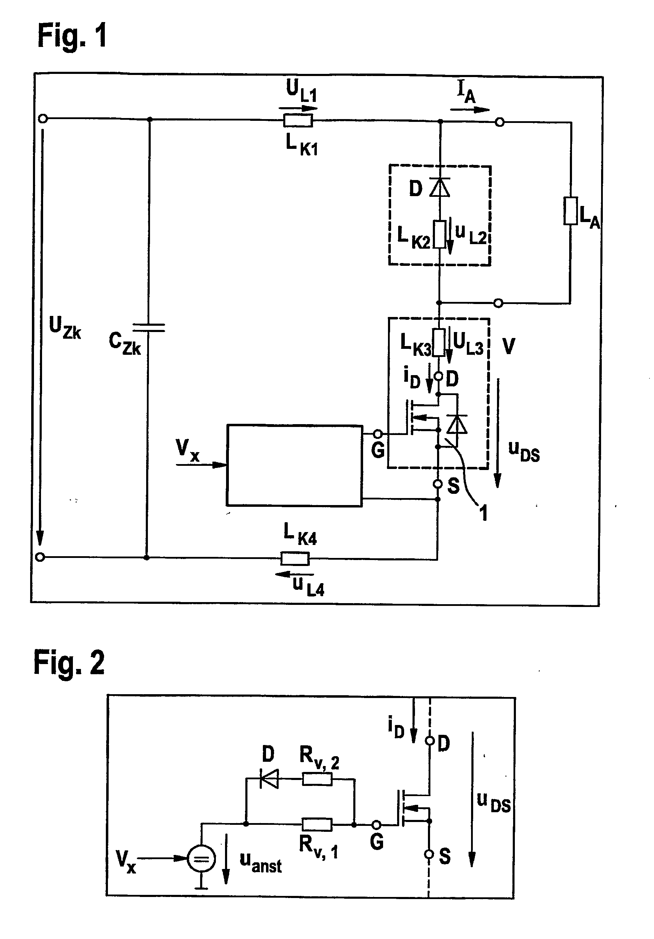

In Figur 1 ist ein leistungselektronisches Stellglied dargestellt, das einen spannungsgesteuerten Halbleiterschalter, insbesondere einen MOSFET oder einen IGBT aufweist und als Grundansteuerschaltung für verschiedene leistungselektronische Schaltungen, wie z. B. Gleichstromsteller, Pulswechselrichter, usw. dient. In Figur 1 ist ein über ein Halbleiterschalter 1 zu schaltender Strompfad dargestellt, der eine induktive Last $L_A$ aufweist. Parallel zur induktiven Last $L_A$ ist eine Freilaufdiode $D_A$ geschaltet. Weiterhin weist die Anordnung einen Zwischenkreiskondensator $C_{Zk}$ auf. Die Leitungen des Strompfades zwischen den Bauelementen weisen parasitäre Leitungsinduktivitäten $L_{K1}$, $L_{K2}$, $L_{K3}$, $L_{K4}$ auf. Als Halbleiterschalter kann beispielsweise ein MOSFET verwendet werden. Im dargestellten Ausführungsbeispiel handelt es sich um einen selbstsperrenden N-Kanal-MOSFET 1. Es ist auch möglich als Halbleiterschalter einen IGBT oder andere Halbleiterbauelemente vorzusehen, um den Schaltvorgang des leistungselektronischen Stellgliedes durchzuführen.

Nachfolgend wird die Erfindung ausgehend von einem leistungselektronischen Stellglied mit dem N-Kanal-MOSFET-Transistor 1 beschrieben.

Um mit Hilfe des MOSFETs 1 den Schaltvorgang durchzuführen muss der MOSFET vom leitenden in den sperrenden bzw. vom sperrenden in den leitenden Zustand überführt werden. Dazu muss dessen Gate-Source-Kapazität entladen bzw. aufgeladen werden. Für einen möglichst schnellen Übergang, d. h. im Bereich von üblicherweise einigen 100 ns, ist daher ein vergleichsweise großer Umladestrom von üblicherweise 0,5 bis 4 A erforderlich. Dieser Umladestrom wird nach dem Stand der Technik von speziellen Treiberschaltungen zur Verfügung gestellt.

In Figur 2 ist ein vereinfachtes Ersatzschaltbild einer solchen Treiberschaltung gemäß dem Stand der Technik dargestellt, die eine ideale Spannungsquelle $U_{anst}$ und Gate-Vorwiderstände $R_{V,1}$, $R_{V,2}$ aufweist. Mit Hilfe eines Schaltbefehls $V_x$ wird der MOSFET ein- bzw. ausgeschaltet. Über die Wahl der Gate-Vorwiderstände $R_{v,1}$ bzw. $R_{v,2}$ kann die Höhe des Ansteuerstroms in den Gate-Anschluss verändert und damit die Schaltgeschwindigkeit des Leistungshalbleiters beeinflusst werden. Zusätzlich kann über eine Diodenschaltung mit einer Diode $D_v$, die in Serie zu dem zweiten Gate-Vorwiderstand $R_{v,2}$ geschaltet ist, dafür gesorgt werden, dass der beim Aufladen wirksame Gate-Vorwiderstand einen größeren Wert aufweist, als derjenige beim Entladen der Gate-Source-Kapazität. Aufgrund des größeren Gate-Stroms läuft daher der Abschaltvorgang schneller als der Einschaltvorgang ab. Durch eine geeignete Dimensionierung der Spannungsquelle $U_{anst}$ sowie der Gate-Vorwiderstände $R_{v,1}$, $R_{v,2}$ lässt sich die Geschwindigkeit des Ein- und Ausschaltvorgangs des MOSFETs einstellen. So kann beispielsweise durch eine langsamere Aufladung bzw. Entladung der Gate-Source-Kapazität eine geringere Änderungsgeschwindigkeit des Drain-Stromes $di_D/dt$ durch den MOSFET erreicht werden, um so unerwünschte Effekte, wie eine schädlich hohe Überspannung zwischen dem Drain- und Source-Anschluss aufgrund der parasitären Induktivitäten, Störemissionen und Diodenrückströme zu verringern.

Andererseits ist bei einer Verlangsamung des Aus- bzw. Einschaltvorgangs der MOSFET länger in einem aktiven Betriebszustand, wobei eine hohe Schaltverlustleistung in dem MOSFET erzeugt wird.

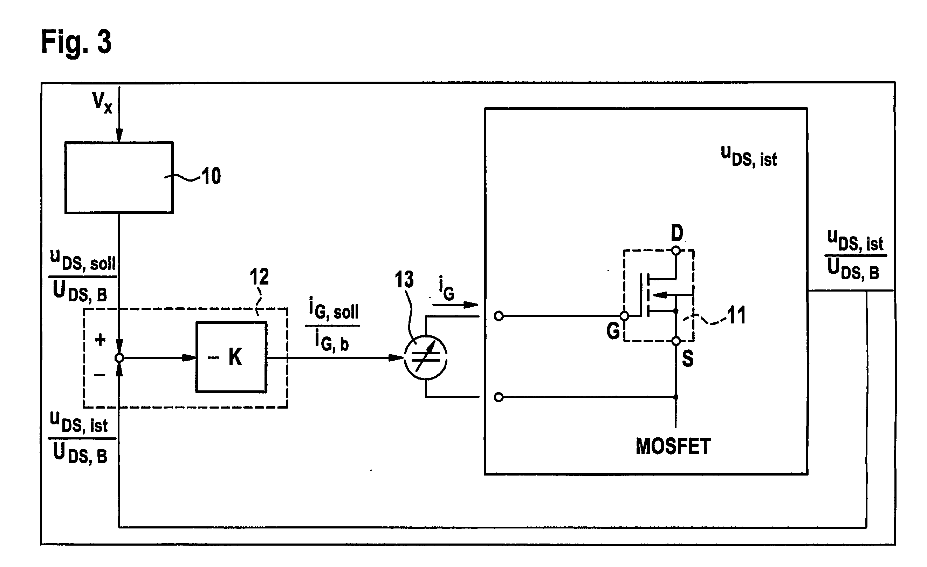

In Figur 3 ist ein Blockschaltbild einer erfindungsgemäßen Ansteuerschaltung dargestellt. Diese Schaltung umfasst einen Sollwertgenerator 10, der aus dem logischen Schaltsignal $V_x$, das einen Einschaltzustand oder Ausschaltzustand für den zu schaltenden Strompfad angibt, eine gewünschte Soll-Anschlussspannung für die Drain-Source-Spannung $U_{DS}$ des MOSFETs 11 generiert. Weiterhin ist eine Regelungseinheit 12 vorgesehen, die einen Proportional-Regler umfasst. Der Regelungseinheit 12 wird die von dem Sollwert-Generator 10 generierte Soll-Anschlussspannung $U_{DS,soll}$ und die momentane Ist-Anschlussspannung $U_{DS,ist}$, das ist die Drain-Source-Spannung $U_{DS}$, zugeführt. Die Differenz zwischen diesen beiden Größen stellt die Eingangsgröße für die Regelungseinrichtung 12 dar.

Die Regelungseinrichtung 12 ist mit einem Ausgang und einer steuerbaren Stromquelle 13 verbunden, die mit dem Gate-Anschluss des MOSFETs verbunden ist. Abhängig von der Ansteuerung durch die Regelungseinrichtung 12 stellt die gesteuerte Stromquelle einen Lade- bzw. Entladestrom für die Gate-Source-Kapazität des MOSFETs 11 ein. Bei einem Proportional-regler ist die Abhängigkeit zwischen der Eingangsgröße und der Ausgangsgröße in der Regel durch einen proportionalen Zusammenhang, beispielsweise durch den Faktor -K, bestimmt.

Der Gate-Strom, der durch die gesteuerte Stromquelle 13 generiert wird, bestimmt dann mittelbar die Änderungsgeschwindigkeit $di_D/dt$ des Drain-Stroms. Übersteigt die Ist-Anschlussspannung $U_{DS,ist}$ die vorgegebene Soll-Anschlussspannung $U_{DS,soll}$ bewirkt die Regelungseinrichtung 12 dass der Gate-Strom und damit auch die Änderungsgeschwindigkeit $di_D/dt$ des Drain-Stroms reduziert wird. Dies erfolgt jedoch nur in den Zeitabschnitten der Schaltvorgänge, in denen die Drain-Source-Spannung $U_{DS}$ ohne Eingriff der Regelung über die vorgegebene Soll-Anschlussspannung ansteigen würde. Während der übrigen Zeitabschnitte der Schaltvorgänge ist die Regelungseinrichtung 12 so geschaltet, dass sie keine unnötige Reduktion des Gate-Stroms und damit der Änderungsgeschwindigkeit $di_D/dt$ des Drain-Stroms vornimmt. Somit erhöhen sich die Schaltverluste durch den Einsatz der Regelung nur in dem Maße, wie es zur Reduktion der Überspannungen bzw. zur Beeinflussung des Schaltverhaltens notwendig ist.

Durch eine solche Ansteuerung kann ein Kompromiss zwischen den Schaltverlusten einerseits und den bei den Schaltvorgängen entstehenden Überspannungen sowie Störemissionen andererseits erzielt werden. Durch Vorgabe der Soll-Anschlussspannung $U_{DS,soll}$ wird die Änderungsgeschwindigkeit $di_D/dt$ gerade so groß gewählt, dass die vorgegebenen Grenzen für die Überspannungen bzw. Störemissionen eingehalten werden können.

Durch die erfindungsgemäße Ansteuerschaltung können während der Schaltvorgänge in der leistungselektronischen Schaltung die Drain-Source-Spannung $U_{DS}$ des MOSFETs begrenzt werden und die Kommutierungsspannung direkt vorgegeben werden. Damit kann die Spannungsfestigkeit der eingesetzten Leistungs-MOSFETs optimal ausgenutzt werden und die bei einer nicht geregelten Ansteuerung im Betrieb auftretenden Schwingungen und die damit zusammenhängenden Störemissionen erheblich verringert werden. Dies resultiert daraus, dass durch die Begrenzung der Überspannung die angeregte Oszillation ein kleinere Anfangsamplitude aufweist und somit schneller abklingt. Dies führt zu geringeren elektromagnetischen Störemissionen, so dass Filter und Schirmungsmaßnahmen weniger aufwändig und damit kostengünstiger realisiert werden können.

Darüber hinaus nimmt bei Verwendung des Leistungs-MOSFETs der Einschaltwiderstand $R_{DS,on}$ überproportional mit der maximalen Sperrspannung zu und verhält sich umgekehrt proportional zur Chip-Fläche des MOSFETs. Die Begrenzung der Überspannung ermöglicht den Einsatz von MOSFETs mit kleinerer Durchbruchsspannung. Diese weisen bei gleicher Chip-Fläche einen niedrigeren Einschaltwiderstand $R_{DS,on}$ auf, so dass der Wirkungsgrad der Leistungselektronik gesteigert werden kann. Werden andererseits MOSFETs mit kleinerer Baugröße eingesetzt, die aber trotzdem noch den gleichen Einschaltwiderstand wie ein größerer MOSFET besitzen, ergibt sich eine Kosten- und Bauraumreduktion.

Die Änderungsgeschwindigkeit $di_D/dt$ des Drain-Stroms während eines Schaltvorgangs ergibt sich mit der Zwischenkreisspannung $U_{Zk}$ aus nachfolgender Beziehung:

$$\frac{di_D}{dt} = \frac{U_{Zk} - u_{DS}}{\sum_{V} L_{KV}} \ .$$

Da die Größe $L_{KV}$ aller im Strompfad vorhandenen parasitären Induktivitäten nicht exakt bekannt ist, kann mit der Regelung der erfindungsgemäßen Ansteuerschaltung die Änderungsgeschwindigkeit des Drain-Stroms $di_D/dt$ nicht direkt vorgegeben werden, da die Regelung die Ist-Anschlussspannung auf eine vorgegebene Soll-Anschlussspannung einstellt.

Je nach Schaltvorgang müssen unterschiedliche Werte der Soll-Anschlussspannung $U_{DS,soll}$ vorgegeben werden. Bei einem Abschaltvorgang ergibt sich eine negative Änderungsgeschwindigkeit $di_D/dt$ des Drain-Stroms, wobei der Drain-Strom bis auf 0A reduziert wird. Um diese negative Stromänderungsgeschwindigkeit einstellen zu können, muss die Spannungsdifferenz $U_{zk}$ -$U_{DS}$ ebenfalls negativ sein. Somit muss während eines Abschaltvorgangs die Soll-Anschlussspannung $U_{DS,soll}$ für die Drain-/Source-Spannung vorgegeben werden, welche größer ist als die Zwischenkreisspannung $U_{Zk}$. Je größer die Soll-Anschlussspannung $U_{DS,soll}$ desto größer wird der Spannungsabfall an den parasitären Induktivitäten während des Schaltvorgangs und damit die Änderungsgeschwindigkeit $di_D/dt$ des Drain-Stroms.

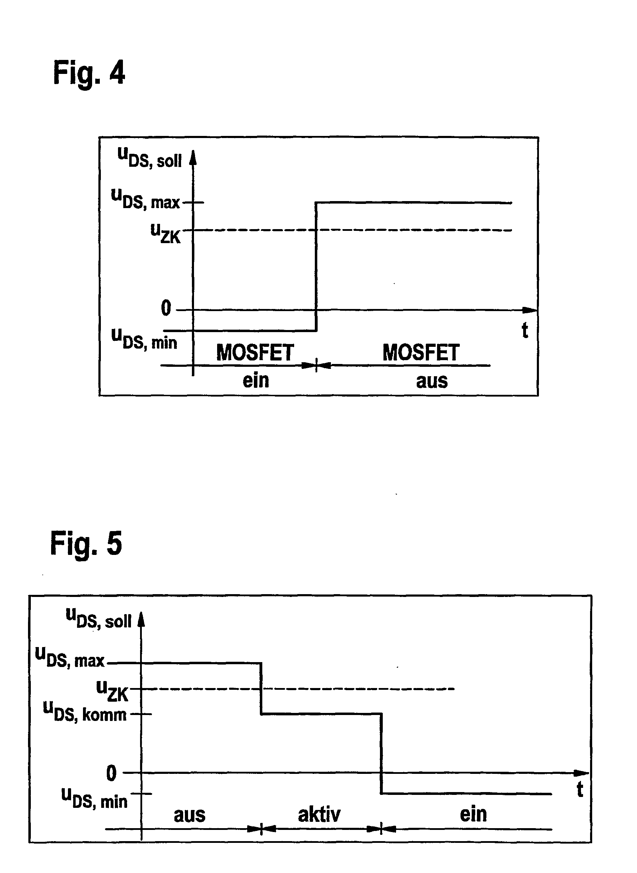

In Figur 4 ist der sich ergebene Verlauf der vorgegebenen Soll-Anschlussspannung $U_{DS,soll}$ aufgetragen. Man erkennt, dass im eingeschalteten Zustand des MOSFET 11 eine konstante Soll-Anschlussspannung kleiner 0 vorgegeben wird. Damit ist sichergestellt, dass die Gate-Source-Kapazität auf die maximal mögliche Spannung aufgeladen wird und der MOSFET 11 vollständig eingeschaltet ist. Die maximal mögliche Spannung ergibt sich aus der Auslegung der gesteuerten Stromquelle und entspricht in der Regel in etwa der positiven Versorgungsspannung der gesteuerten Stromquelle 13.

Soll der MOSFET gemäß eines an einem Eingang des Sollwertgenerators 10 bereitgestellten Schaltsignals $V_x$ abgeschaltet werden, wird als Wert für die Soll-Anschlussspannung ein Wert gewählt, der entsprechend der Belastbarkeit des MOSFETs 11 vorgegeben wird. Die Soll-Anschlussspannung $U_{DS,soll}$ ist kleiner als die Durchbruchsspannung des MOSFETs 11 zu wählen, um eine Zerstörung des MOSFETs 11 durch einen Spannungsdurchbruch zu verhindern. Die Regelungseinrichtung 12 gibt den Gate-Strom $i_G$ dann so vor, dass die Anschlussspannung $U_{DS}$ am MOSFET 11 die Soll-Anschlussspannung erreicht aber im Wesentlichen nicht übersteigt. Die während des Abschaltvorgangs an der gesamten Kommutierungsinduktivität $L_{KV}$ abfallende Spannung wird von der Regelungseinrichtung somit auf die Soll-Anschlussspannung $U_{Zk} - U_{DS,max}$ eingestellt. Daraus ergibt sich entsprechend oben angegebener Beziehung die Änderungsgeschwindigkeit $di_D/dt$ des Drain-Stroms.

Sobald der Diodenstrom durch die Freilaufdiode $D_A$ seinen Endwert $I_A$ und der Drain-Strom $i_D$ den Wert 0 erreicht hat, und somit die Kommutierung beendet ist, fällt an den Induktivitäten $L_{K1}$ bis $L_{K4}$, $L_A$ keine nennenswerte Spannung mehr ab. Die Anschlussspannung über dem MOSFET 11 entspricht dann im ausgeschalteten Zustand der Zwischenkreisspannung $U_{Zk}$. Die Regelungseinrichtung 12 versucht jedoch weiterhin, die Anschlussspannung $U_{DS}$ auf den vorgegebenen Sollwert von $U_{DS,max}$ zu halten und stellt demzufolge einen negativen Gate-Strom $i_G$ ein, wodurch die Gate-Source-Kapazität weiter entladen wird. Durch das Beibehalten des Anlegens der Soll-Anschlussspannung $U_{DS,Soll}$ nach Abschluss der Kommutierung wird also erreicht, dass die Regelungseinrichtung die Gate-Source-Kapazität bis auf die minimale Spannung entlädt, die durch die negative Versorgungsspannung der gesteuerten Stromquelle 13 vorgegeben ist. Somit ist sichergestellt, dass der MOSFET 11 aufgrund von Störeinkopplungen im Ansteuerkreis nicht unbeabsichtigt leitend wird.

Entsprechend dem Vorgehen beim Abschaltvorgang wird auch beim Einschaltvorgang durch die Wahl eines geeigneten Sollwertes für die Soll-Anschlussspannung $U_{DS,soll}$, die Kommutierungsspannung an den parasitären Induktivitäten vorgegeben. Figur 5 zeigt den Verlauf des Sollwertes $U_{DS,soll}$ bei einem Einschaltvorgang gemäß einer bevorzugten Ausführungsform der Erfindung.

Beim Einschalten ergibt sich eine positive Änderungsgeschwindigkeit $di_D/dt$ des Drain-Stroms der von 0 auf $I_A$ ansteigt. Um den Drain-Strom aufbauen zu können, muss die Spannungsdifferenz zwischen der Zwischenkreisspannung $U_{Zk}$ und der Anschlussspannung $U_{DS}$ des MOSFETs 11 positiv sein. Während eines Einschaltvorgangs ist daher ein Sollwert $U_{DS,komm}$ erforderlich, der kleiner als die Zwischenkreisspannung $U_{Zk}$ ist. Zum Einschalten des MOSFETs 11 wird deshalb zunächst ein erster Sollwert $U_{DS,komm}$, die Kommutierungsspannung, vorgegeben, bei dem der MOSFET 11 in einem aktiven Betriebsbereich arbeitet. Sobald die Regelungseinrichtung 12 die Anschlussspannung $U_{DS}$ auf diesen Wert eingestellt hat, fällt an den parasitären Induktivitäten die Differenzspannung zwischen der Zwischenkreisspannung $U_{Zk}$ und der Kommutierungsspannung $U_{DS,komm}$ ab, wodurch die Änderungsgeschwindigkeit $di_D/dt$ des Drain-Stroms bestimmt ist.

Nach dem Abschluss des Kommutierungsvorgangs muss der MOSFET 11 möglichst schnell vollständig eingeschaltet werden, indem als Soll-Anschlussspannung $U_{DS,min}$ kleiner gleich 0 vorgegeben wird. Dies ist notwendig, da während des Kommutierungsvorgangs der MOSFET im aktiven Arbeitsbereich arbeitet, bei dem sehr hohe Durchlassverluste im MOSFET entstehen, die bereits nach kurzer Zeit zu dessen Zerstörung führen können. Die Regelungseinrichtung 12 wird also nach Beenden des Kommutierungsvorgangs die Soll-Anschlussspannung $U_{DS,soll}$ auf den Minimumwert der Anschlussspannung $U_{DS,min}$ einstellen. Das Einstellen von negativen Soll-Anschlussspannungen $U_{DS,soll}$ kann von der Regelung zwar nicht erreicht werden, somit wird jedoch sichergestellt, dass die Gate-Source-Kapazität auf die maximal mögliche Spannung, die der positiven Versorgungsspannung der gesteuerten Stromquelle 13 entspricht, aufgeladen wird und der MOSFET 11 somit vollständig eingeschaltet ist.

Würde zu Beginn des Einschaltvorgangs die Soll-Anschlussspannung unmittelbar auf die Minimum-Anschlussspannung $U_{DS,min}$ eingestellt werden, und der Zeitabschnitt, in dem der MOSFET 11 in dem aktiven Arbeitsbereich betrieben wird ausgelassen, würde die Regelungseinrichtung 12 versuchen, den MOSFET 11 schnellstmöglich vollständig einzuschalten. Dies hätte zur Folge, dass die Kommutierungsspannung $U_{Zk} - U_{DS}$ an den Induktivitäten und damit auch die Änderungsgeschwindigkeit $di_D/dt$ des Drain-Stroms sehr groß werden, so dass der Schaltvorgang nahezu dem bei Ansteuerung nach dem Stand der Technik entsprechend würde. In diesem Fall wäre eine Reduzierung der Störemission nicht erreichbar.

Um den Einschaltvorgang zweistufig durchzuführen, steht die Regelungseinrichtung 12 mit dem Sollwertgenerator 10 in Verbindung, so dass die Regelungseinrichtung 12 den Zeitpunkt des Wechsels der Vorgabe des ersten Sollwertes zur Vorgabe des zweiten Sollwertes vorgeben kann. Das Einstellen der Soll-Anschlussspannung $U_{DS,soll}$ auf die Kommutierungsspannung $U_{DS,komm}$ wird durch die fallende Flanke des Schaltbefehls $V_x$ der überlagerten Regelung aktiviert. Der Schaltbefehl $V_x$ gibt an, dass der Strompfad eingeschaltet oder ausgeschaltet werden soll. Der Zeitpunkt, zu dem die Soll-Anschlussspannung auf die Minimum-Anschlussspannung $U_{DS,min}$ eingestellt wird, wird durch ein weiteres Umschaltsignal $V_x'$ vorgegeben, dass im Sollwert-Generator 10 erzeugt wird.

Das weitere Umschaltsignal $V_x'$ kann zum einen zeitverzögert aus dem Schaltsignal $V_x$ erzeugt werden, indem die Zeitdauer so groß gewählt wird, dass nach ihrem Ablauf der Einschaltvorgang auf jeden Fall abgeschlossen ist. Dies ist notwendig, um sicher zu verhindern, dass die Regelung der Anschlussspannung $U_{DS}$ noch während des Kommutierungsvorgangs versucht, den MOSFET 11 vollständig einzuschalten. Alternativ dazu kann das Umschaltsignal $V_x'$ aus Signalen abgeleitet werden, welche in der Ansteuerschaltung ohnehin zur Verfügung stehen. Hierfür kommen die Anschlussspannung $U_{DS}$, die Gate-Source-Spannung $U_{GS}$ oder der Gate-Strom-Sollwert $i_{G,soll}$ in Frage.

Die zeitverzögerte Erzeugung des weiteren Umschaltsignals $V_x$' aus dem Schaltsignal $V_x$ kann beispielsweise mit einem RC-Glied und anschließendem Schmitt-Trigger oder ähnlichen realisiert werden. Der Nachteil hierbei ist, das die Verzögerungszeit mindestens so groß wie die längste auftretende Kommutierungsdauer sein muss. Bei Schaltvorgängen, die kürzere Kommutierungszeiten aufweisen, treten dann unnötig hohe Einschaltverluste auf, da der MOSFET länger als notwendig im aktiven Zustand gehalten wird. Im Idealfall müsste das Umschaltsignal $V_x$' genau das Ende des Kommutierungsvorgangs signalisieren. Das Ende des Kommutierungsvorgangs ist jedoch aus dem Signalverläufen im Strompfad oder im Regelungskreis nicht zu ermitteln.

Aus den verfügbaren Signalverläufen lässt sich nur der Beginn der Kommutierung ausreichend genau ermitteln. Nach dem Beginn der Kommutierung muss somit auch bei der zweiten Variante die maximal für eine Kommutierung benötigte Zeit abgewartet werden, um sicher zu stellen, dass der MOSFET erst dann vollständig eingeschaltet wird, wenn die Kommutierung auf jeden Fall abgeschlossen ist.

Obwohl nur der Beginn der Kommutierung erkannt werden kann und obwohl wegen der dort fest eingestellten Verzögerungszeit die Einschaltverluste aufgrund des Betreibens des MOSFETs 11 im aktiven Arbeitsbereich über den Abschluss der Kommutierung hinaus erhöht sind, ist es durch die Bestimmung des Kommutierungsbeginns jedoch möglich, den Zeitpunkt des Schaltvorgangs der Soll-Anschlussspannung von der Kommutierungsspannung $U_{DS,komm}$ zur Minimum-Spannung $U_{DS,min}$ für jeden Betriebsbereich besser an das Ende der Kommutierung anzunähern. Veränderliche Parameter, wie beispielsweise die Aufladezeit, die benötigt wird, um die entladene Gate-Source-Kapazität bis zur Schwellenspannung des MOSFETs 11 aufzuladen und die sowohl von der Chip-Temperatur als auch von der Gate-Source-Kapazität abhängig ist, müssen nicht bei der Festlegung der Zeitdauer bis zum Anlegen des zweiten Sollwertes berücksichtigt werden. Diese Abhängigkeiten müssen bei der zeitverzögerten Erzeugung des Umschaltsignals $V_x$' bei der Bestimmung der Verzögerungszeit mit ihren jeweiligen Maximalwerten berücksichtigt werden, damit sichergestellt werden kann, dass der MOSFET 11 erst dann vollständig eingeschaltet wird, wenn die Kommutierung abgeschlossen ist. Wird dagegen der Beginn der Kommutierung als Basis zur Generierung des weiteren Umschaltsignals $V_x$' verwendet, muss die Aufladezeit der Gate-Source-Kapazität nicht berücksichtigt werden. Die so eingestellte Verzögerungszeit entspricht daher wesentlich genauer der tatsächlichen Kommutierungsdauer, so dass unnötig hohe Einschaltverluste vermieden werden.

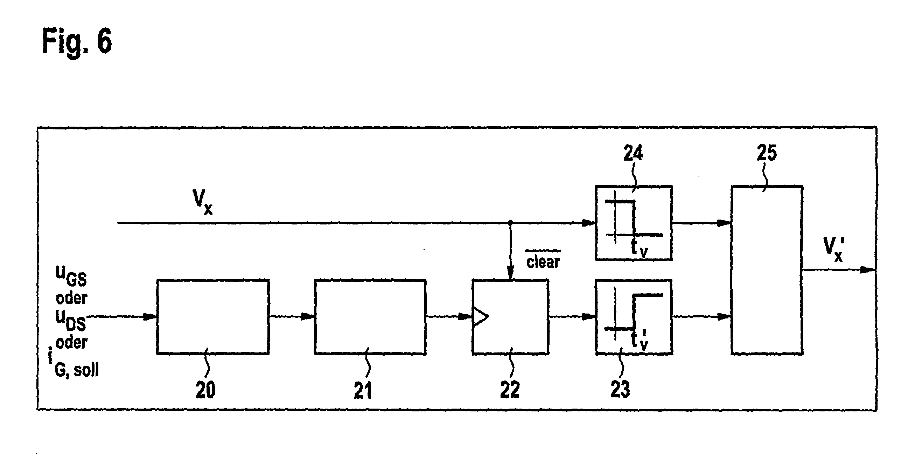

In Figur 6 ist ein Blockschaltbild der Schaltung zur Erzeugung des weiteren Umschaltsignals $V_x$' aus einer der in dem Strompfad bzw. in der Ansteuerschaltung vorliegenden elektrischen Größen dargestellt. Es ist möglich, das Umschaltsignal $V_x$' aus der Gate-Source-Spannung $U_{GS}$, der Drain-Source-Spannung $U_{DS}$ oder dem Gate-Strom-Sollwert $i_{G,soll}$ zu erzeugen. Die elektrische Größe, die zur Bestimmung des Kommutierungsbeginns verwendet wird, wird zunächst in einer Signalaufbereitungseinheit 20 aufbereitet, d. h. verstärkt, differenziert, gefiltert oder ähnliches und anschließend einem Komparator 21 zugeführt, dessen Schaltschwelle so festgelegt ist, dass er umschaltet, sobald der Kommutierungsbeginn im Eingangssignal erkennbar ist. Diese Schaltschwelle hängt von der verwendeten elektrischen Größe ab. Mit der steigenden Flanke des Ausgangssignals des Komparators 21, die den Beginn der Kommutierung anzeigt, wird das nachfolgende Flip-Flop 22 gesetzt. Je nach verwendeter elektrischer Größe nimmt ein Ausgangskomparator 21 nur für eine kurze Zeit den High-Pegel an, so dass die Speicherung des erfolgten Ergebnisses mit Hilfe des Flip-Flops 22 notwendig ist. Das durch ein Verzögerungsglied 23 um eine Zeitdauer verzögerte Ausgangssignal des Flip-Flops 22 ist im Prinzip schon das gewünschte Umschaltsignal $V_x$'. Da bei Anlegen eines Ausschaltbefehls das Schaltsignal $V_x$ auf einen Low-Zustand übergeht, muss das Umschaltsignal $V_x$' ebenfalls den Low-Zustand annehmen. Dazu ist der Rücksetzeingang des Flip-Flops 22 mit dem Schaltsignal $V_x$ verbunden. Das Flip-Flop 22 wird somit zurückgesetzt, sobald das Schaltsignal $V_x$ auf einen Low-Zustand übergeht.

Aufgrund einer möglichen Fehlfunktion der Schaltung zur Detektion des Beginns der Kommutierung ist es denkbar, dass das Umschaltsignal $V_x$' nicht oder nicht rechtzeitig erzeugt wurde, und somit der MOSFET 11 nicht vollständig eingeschaltet wird. Er würde dann weiterhin im aktiven Arbeitsbereich betrieben und die dann entstehenden Durchlassverluste führten in Folge zu seiner Zerstörung. Aus diesem Grund ist die Schaltung zunächst mit einer reinen Zeitsteuerung, die durch das weitere Verzögerungselement 24 gebildet wird, versehen. Die Ausgangssignale an den Ausgängen der beiden Verzögerungselemente 23, 24 sind mit einem Oder-Gatter 25 verknüpft. Sobald nun der für die Detektion des Kommutierungsbeginns untere Signalpfad durch das Verzögerungselement 23 ausfällt, wird durch die zusätzliche Zeitsteuerung dafür gesorgt, dass der MOSFET 11 nach Ablauf der Zeitdauer vollständig eingeschaltet wird.

Es ist möglich, den Verlauf der Gate-Source-Spannung $U_{GS}$ zu verwenden, um den Kommutierungsbeginn zu detektieren. Dabei wird die Tatsache ausgenutzt, dass die Ableitung der Gate-Source-Spannung nach dem Auftreten des Schaltbefehls $V_x$ sich erstmals dem Wert 0 nähert, wenn die Kommutierung einsetzt. Die Ableitung der Gate-Source-Spannung kann durch ein Differenzierglied gebildet werden, wobei es sinnvoll ist, dem Differenzierglied einen Tiefpass nachzuschalten, um hochfrequente Störsignale herauszufiltern.

Nach dem Auftreten des Schaltbefehls $V_x$ wird vom Sollwert-Generator 10 die Soll-Anschlussspannung $U_{DS,soll}$ auf die Kommutierungsspannung $U_{DS,komm}$ ein-

gestellt, um ein Absinken der Drain-Source-Spannung $U_{DS}$ einzuleiten. Sobald die Drain-Source-Spannung $U_{DS}$ die Zwischenkreisspannung $U_{Zk}$ unterschritten hat, fällt an den parasitären Induktivitäten eine positive Spannung ab und der Kommutierungsvorgang beginnt. Anhand des Verlaufs der Drain-Source-Spannung kann der Kommutierungsbeginn nun bestimmt werden. Dazu ist ein Komparator vorgesehen, der detektiert, wann die Drain-Source-Spannung $U_{DS}$ zum ersten Mal nach Auftreten des Schaltbefehls $V_x$ eine Schwellenspannung unterschreitet, die zwischen der auf die Kommutierungsspannung $U_{DS,komm}$ eingestellten Soll-Anschlussspannung $U_{DS,soll}$ und der Zwischenkreisspannung $U_{Zk}$ liegen muss.

Es kann ebenso vorgesehen sein, dass der Kommutierungsbeginn anhand des Verlaufs des Gate-Strom-Sollwertes $i_{G,soll}$ festgestellt wird. Dabei macht man sich zu nutze, dass die Drain-Source-Spannung $U_{DS}$ nach dem Auftreten des Einschaltbefehls auf die mittels der Kommutierungsspannung $U_{DS,komm}$ eingestellte Soll-Anschlussspannung $U_{DS,soll}$ absinkt. Währenddessen verringert sich der Betrag der Regelabweichung von $U_{DS,komm} - U_{Zk}$ auf 0V, wenn $U_{DS}$ den eingestellten Sollwert erreicht hat, so dass der Proportionalregler den Gate-Strom-Sollwert kontinuierlich bis auf 0 zurücknimmt. Mit Hilfe des Komparators 21 wird nun detektiert, zu welchem Zeitpunkt der Gate-Strom-Sollwert zum ersten Mal nach dem Auftreten des Schaltbefehls $V_x$ eine Schwellenspannung unterschreitet, die oberhalb von 0 und unterhalb des Gate-Strom-Sollwertes $I_{G,soll}$ liegen muss, welcher unmittelbar nach dem Auftreten des Schaltbefehls $V_x$ von der Regeleinrichtung 12 ausgegeben wird.

**Patentansprüche**

1.  Ansteuerschaltung zum Ansteuern einer leistungselektronischen Schaltung, die einen.Strompfad durch einen Halbleiterschalter (1) und eine Leitung aufweist, wobei die Induktivität der Leitung und/oder eines Bauteils im Strompfad beim Schalten des Halbleiterschalters (1) zu einer Überspannung zwischen einem ersten und einem zweiten stromführenden Anschluss des Halbleiterschalters führt, **dadurch gekennzeichnet, dass** die Ansteuerschaltung eine steuerbare Stromquelle (13), um einen ladungsgesteuerten Steueranschluss des Halbleiterschalters (1) mit einem Steuerstrom zu laden bzw. zu entladen, und eine Steuereinheit (12) aufweist, wobei die Steuereinheit (12) einen P-Regler aufweist, dem eine Anschlussspannung ($U_{DS}$) zwischen den stromführenden Anschlüssen des Halbleiterschalters (1) und eine vorgegebene Soll-Anschlussspannung ($U_{DS,soll}$) zugeführt wird, und der die Stromquelle (13) so ansteuert, dass bei einem Schaltvorgang die Anschlussspannung ($U_{DS}$)

über den stromführenden Anschlüssen des Halbleiterschalters (1) die Soll-Anschlussspannung ($U_{DS,soll}$) nicht übersteigt.

2.  Ansteuerschaltung nach Anspruch 1, **dadurch gekennzeichnet, dass** die Soll-Anschlussspannung ($U_{DS,soll}$) von der maximal zulässigen Anschlussspannung zwischen den stromführenden Anschlüssen des Halbleiterschalters (1) abhängt.

3.  Ansteuerschaltung nach Anspruch 1 oder 2, **dadurch gekennzeichnet, dass** die Steuereinheit (12) eine Vergleicherschaltung aufweist, um die Anschlussspannung ($U_{DS}$) mit der Soll-Anschlussspannung ($U_{DS,soll}$) zu vergleichen und die Stromquelle (13) abhängig von dem Ergebnis des Vergleichens anzusteuern.

4.  Ansteuerschaltung nach Anspruch 3, **dadurch gekennzeichnet, dass** die Steuereinheit (12) einen P-Regler aufweist, um die Stromquelle (13) so anzusteuern, dass eine Änderung des Steuerstromes proportional zur Differenz zwischen der Anschlussspannung ($U_{DS}$) und der Soll-Anschlussspannung ($U_{DS,soll}$) ist.

5.  Ansteuerschaltung nach einem der Ansprüche 1 bis 4, **dadurch gekennzeichnet, dass** die Soll-Anschlussspannung ($U_{DS,soll}$) bei einem Ausschaltvorgang oder einem Einschaltvorgang größer als die an dem Strompfad angelegte Betriebsspannung ist.

6.  Ansteuerschaltung nach Anspruch 5, **dadurch gekennzeichnet, dass** der Steuereingang des Halbleiterschalters (1) über die Stromquelle auf ein Potential aufladbar ist, das niedriger ist als das niedrigste Potential des Strompfades.

7.  Ansteuerschaltung nach einem der Ansprüche 1 bis 6, **dadurch gekennzeichnet, dass** die Steuereinheit bei einem Einschaltvorgang die Soll-Anschlussspannung ($U_{DS,Soll}$) zunächst auf einen ersten Sollwert eingestellt und nach Ablauf einer Zeitdauer auf einen zweiten Sollwert einstellt, wobei der zweite Sollwert kleiner oder gleich einem niedrigen Betriebspotential bei einem selbstsperrenden Halbleiterschalter (1) bzw. größer oder gleich einem hohen Betriebspotential bei einem selbstleitenden Halbleiterschalter ist.

8.  Ansteuerschaltung nach Anspruch 7, **dadurch gekennzeichnet, dass** der erste Sollwert so gewählt ist, dass der Halbleiterschalter (1) in seinem aktiven Betriebsbereich arbeitet.

9.  Ansteuerschaltung nach Anspruch 7 oder 8, **dadurch gekennzeichnet, dass** ein Verzögerungselement (24) vorgesehen ist, um die Zeitdauer beginnend mit dem Einschaltvorgang fest vorzugeben, wobei die Zeitdauer mindestens der Zeit entspricht, nach der der Einschaltvorgang auf jeden Fall abgeschlossen ist.

10. Ansteuerschaltung nach Anspruch 7 oder 8, **dadurch gekennzeichnet, dass** eine Zeitsteuereinheit vorgesehen ist, um die Soll-Anschlussspannung ($U_{DS,soll}$) abhängig von einem Strom- und/oder Spannungsverlauf in dem Strompfad einzustellen.

11. Ansteuerschaltung nach Anspruch 10, **dadurch gekennzeichnet, dass** der Halbleiterschalter (1) ein Feldeffekttransistor aufweist, wobei die Anschlussspannung eine Drain-Source-Spannung zwischen einem Drain-Anschluss und einem Source-Anschluss darstellt und der Steuereingang den Gate-Anschluss darstellt.

12. Ansteuerschaltung nach Anspruch 11, **dadurch gekennzeichnet, dass** die Zeitdauer durch einen Kommutierungsbeginn und einer maximalen Kommutierungsdauer nach dem Beginn des Einschaltvorgangs bestimmt ist, wobei der Kommutierungsbeginn **dadurch** bestimmt ist, dass die Steigung der Gate-Source-Spannung zwischen dem Gate-Anschluss und dem Source-Anschluss erstmals nach dem Beginn des Einschaltvorgangs 0 ist.

13. Ansteuerschaltung nach Anspruch 11, **dadurch gekennzeichnet, dass** die Zeitdauer durch einen Kommutierungsbeginn und einer maximalen Kommutierungsdauer nach dem Beginn des Einschaltvorgangs bestimmt ist, wobei der Kommutierungsbeginn **dadurch** bestimmt ist, dass die Drain-Source-Spannung ein Schwellpotential unterschreitet, wobei das Schwellpotential zwischen einem maximalen Betriebspotential und der ersten Soll-Spannung liegt.

14. Ansteuerschaltung nach Anspruch 11, **dadurch gekennzeichnet, dass** die Zeitdauer durch einen Kommutierungsbeginn und einer maximalen Kommutierungsdauer nach dem Beginn des Einschaltvorgangs bestimmt ist, wobei der Kommutierungsbeginn **dadurch** bestimmt ist, dass der Steuerstrom erstmals nach dem Beginn des Einschaltvorgangs einen Schwellwert unterschreitet, wobei der Schwellwert zwischen 0V und einem Steuerstrom-Sollwert liegt.

15. Ansteuerschaltung nach einem der Ansprüche 1 bis 10, **dadurch gekennzeichnet, dass** der Halbleiterschalter ein IGBT-Bauelement aufweist.

16. Verfahren zum Ansteuern einer leistungselektronischen Schaltung, die einen Strompfad durch einen ladungsgesteuerten Halbleiterschalter (1) und eine Leitung aufweist, wobei die Induktivität der Leitung beim Schalten des Halbleiterschalters (1) zu einer Überspannung zwischen einem ersten und einem zweiten stromführenden Anschluss des Halbleiterschalters (1) führt, **dadurch gekennzeichnet, dass** ein Steueranschluss des Halbleiterschalters (1) mit einem Steuerstrom geladen bzw. entladen wird, wobei der Steuerstrom durch einen P-Regler, dem eine Anschlussspannung ($U_{DS}$) zwischen den stromführenden Anschlüssen des Halbleiterschalters (1) und eine vorgegebene Soll-Anschlussspannung ($U_{DS,soll}$) zugeführt wird, so gesteuert wird, dass bei einem Schaltvorgang die Anschlussspannung ($U_{DS}$) des Halbleiterschalters (1) eine vorgegebene Soll-Anschlussspannung ($U_{DS,soll}$) nicht übersteigt.

## Claims

1. Drive circuit for driving a power electronic circuit having a current path through a semiconductor switch (1) and a line, wherein the inductance of the line and/or of a component in the current path during the switching of the semiconductor switch (1) leads to an overvoltage between a first and a second current-carrying terminal of the semiconductor switch, **characterized in that** the drive circuit has a controllable current source (13) in order to charge or discharge a charge-controlled control terminal of the semiconductor switch (1) with a control current, and a control unit (12), wherein the control unit (12) has a P controller, to which a terminal voltage ($U_{DS}$) between the current-carrying terminals of the semiconductor switch (1) and a predetermined desired terminal voltage ($U_{DS,desired}$) are fed and which guides the current source (13) in such a way that, during a switching operation, the terminal voltage ($U_{DS}$) across the current-carrying terminals of the semiconductor switch (1) does not exceed the desired terminal voltage ($U_{DS,desired}$).

2. Drive circuit according to Claim 1, **characterized in that** the desired terminal voltage ($U_{DS,desired}$) is dependent on the maximum permissible terminal voltage between the current-carrying terminals of the semiconductor switch (1).

3. Drive circuit according to Claim 1 or 2, **characterized in that** the control unit (12) has a comparator circuit in order to compare the terminal voltage ($U_{DS}$) with the desired terminals voltage ($U_{DS,desired}$) and to drive the current source (13) depending on the result of the comparison.

4. Drive circuit according to Claim 3, **characterized in that** the control unit (12) has a P controller in order to drive the current source (13) in such a way that a change in the control current is proportional to the difference between the terminal voltage ($U_{DS}$) and the desired terminal voltage ($U_{DS,desired}$).

5. Drive circuit according to any of Claims 1 to 4, **characterized in that** the desired terminal voltage ($U_{DS,desired}$), during a switch-off operation or a switch-on operation, is greater than the operating voltage applied to the current path.

6. Drive circuit according to Claim 5, **characterized in that** the control input of the semiconductor switch (1) can be charged by means of the current source to a potential that is lower than the lowest potential of the current path.

7. Drive circuit according to any of Claims 1 to 6, **characterized in that** the control unit, during a switch-on operation, firstly sets the desired terminal voltage ($U_{DS,desired}$) to a first desired value and, after a time duration has elapsed, sets it to a second desired value, wherein the second desired value is less than or equal to a low operating potential in the:case of a normally off semiconductor switch (1) or greater than or equal to a high operating potential in the case of a normally on semiconductor switch.

8. Drive circuit according to Claim 7, **characterized in that** the first desired value is chosen in such a way that the semiconductor switch (1) operates in its active operating range.

9. Drive circuit according to Claim 7 or 8, **characterized in that** a delay element (24) is provided in order to fixedly predetermine the time duration beginning with the switch-on operation,
wherein the time duration corresponds at least to the time after which the switch-on operation has in any event concluded.

10. Drive circuit according to Claim 7 or 8, **characterized in that** a time control unit is provided in order to set the desired terminal voltage ($D_{DS,desired}$) depending on a current and/or voltage profile in the current path.

11. Drive circuit according to Claim 10, **characterized in that** the semiconductor switch (1) has a field effect transistor, wherein the terminal voltage constitutes a drain-source voltage between a drain terminal and a source terminal and the control input constitutes the gate terminal.

12. Drive circuit according to Claim 11, **characterized in that** the time duration is determined by a beginning of commutation and a maximum commutation duration after the beginning of the switch-on operation, wherein the beginning of commutation is determined by the gradient of the gate-source voltage between the gate terminal and the source terminal being 0 for the first time after the beginning of the switch-on operation.

13. Drive circuit according to Claim 11, **characterized in that** the time duration is determined by a beginning of commutation and a maximum commutation duration after the beginning of the switch-on operation, wherein the beginning of commutation is determined by the drain-source voltage falling below a threshold potential, wherein the threshold potential lies between a maximum operating potential and the first desired voltage.

14. Drive circuit according to Claim 11, **characterized in that** the time duration is determined by a beginning of commutation and a maximum commutation duration after the beginning of the switch-on operation, wherein the beginning of commutation is determined by the control current falling below a threshold value for the first time after the beginning of the switch-on operation, wherein the threshold value lies between 0V and a control current desired value.

15. Drive circuit according to any of Claims 1 to 10, **characterized in that** the semiconductor switch has an IGBT component.

16. Method for driving a power electronic circuit having a current path through a charge-controlled semiconductor switch (1) and a line, wherein the inductance of the line during the switching of the semiconductor switch (1) leads to an overvoltage between a first and a second current-carrying terminal of the semiconductor switch (1),
**characterized in that**
a control terminal of the semiconductor switch (1) is charged or discharged with a control current,
wherein the control current is controlled by a P controller, to which a terminal voltage ($U_{DS}$) between the current-carrying terminals of the semiconductor switch (1) and a predetermined desired terminal voltage ($U_{DS,desired}$) are fed, in such a way that, during a switching operation, the terminal voltage ($U_{DS}$) of the semiconductor switch (1) does not exceed a predetermined desired terminal voltage ($U_{DS,desired}$).

**Revendications**

1. Circuit pilote pour le pilotage d'un circuit électronique de puissance qui présente un parcours de courant qui traverse un commutateur (1) à semi-conducteur et un conducteur, l'inductance du conducteur et/ou d'un composant disposé dans le parcours de courant entraînant lors du branchement du commutateur (1) à semi-conducteur une surtension entre une première et une deuxième borne conductrice de courant du commutateur à semi-conducteur,
**caractérisé en ce que**
le circuit pilote présente une source de courant asservie (13) qui charge ou décharge une borne pilote asservie à la charge du commutateur (1) à semi-conducteur par un courant pilote, et une unité pilote (12),
**en ce que** l'unité pilote (12) présente un régulateur P sur lequel la tension ($U_{DS}$) entre les bornes conductrices de courant du commutateur (1) à semi-conducteur et une tension aux bornes prédéterminée de consigne ($U_{DS, soll}$) sont appliquées et qui pilote la source de courant (13) de telle sorte que lors d'une opération de commutation, la tension ($U_{DS}$) entre les bornes conductrices de courant du commutateur (1) à semi-conducteur ne dépasse pas la tension aux bornes de consigne ($U_{DS, soll}$).

2. Circuit pilote selon la revendication 1, **caractérisé en ce que** la tension aux bornes de consigne ($U_{DS,soll}$) dépend de la tension maximale admissible entre les bornes conductrices de courant du commutateur (1) à semi-conducteur.

3. Circuit pilote selon les revendications 1 ou 2, **caractérisé en ce que** l'unité pilote (12) présente un circuit comparateur qui compare la tension aux bornes ($U_{DS}$) à la tension aux bornes de consigne ($U_{DS, soll}$) et qui pilote la source de courant (13) en fonction du résultat de la comparaison.

4. Circuit pilote selon la revendication 3, **caractérisé en ce que** l'unité pilote (12) présente un régulateur P qui pilote la source de courant (13) de telle sorte que la modification du courant pilote soit proportionnelle à la différence entre la tension aux bornes ($U_{DS}$) et la tension aux bornes de consigne ($U_{DS, soll}$).

5. Circuit pilote selon l'une des revendications 1 à 4, **caractérisé en ce que** lors d'une opération de débranchement ou d'une opération de branchement, la tension aux bornes de consigne ($U_{DS,soll}$) est supérieure à la tension de service appliquée sur le parcours de courant.

6. Circuit pilote selon la revendication 5, **caractérisé en ce que** l'entrée pilote du commutateur (1) à semi-conducteur peut être chargée par la source de courant à un potentiel plus bas que le potentiel le plus bas du parcours de courant.

7. Circuit pilote selon l'une des revendications 1 à 6, **caractérisé en ce que** lors d'une opération de branchement, l'unité pilote établit d'abord la tension aux bornes de consigne ($U_{DS, Soll}$) à une première valeur de consigne et l'établit à une deuxième valeur de consigne après qu'une durée s'est écoulée, la deuxième valeur de consigne étant inférieure ou égale au bas potentiel de service qui rend autobloquant le commutateur (1) à semi-conducteur ou supérieure ou égale au haut potentiel de service qui rend conducteur le commutateur à semi-conducteur.

8. Circuit pilote selon la revendication 7, **caractérisé en ce que** la première valeur de consigne est sélectionnée de telle sorte que le commutateur (1) à semi-conducteur travaille dans sa plage active de service.

9. Circuit pilote selon les revendications 7 ou 8, **caractérisé en ce qu'**un élément de retardement (24) est prévu pour définir la durée à partir du début de l'opération de branchement, la durée correspondant en tout cas au moins à la durée qui s'est écoulée depuis que l'opération de branchement s'est terminée.

10. Circuit pilote selon les revendications 7 ou 8, **caractérisé en ce qu'**il présente une unité de commande temporelle qui règle la tension aux bornes de consigne ($U_{DS, soll}$) en fonction de l'évolution du courant et/ou de la tension dans le parcours de courant.

11. Circuit pilote selon la revendication 10, **caractérisé en ce que** le commutateur (1) à semi-conducteur présente un transistor à effet de champ, la tension aux bornes représentant la tension drain-source entre la borne de drain et la borne de source et l'entrée pilote correspondant à la borne de grille.

12. Circuit pilote selon la revendication 11, **caractérisé en ce que** la durée est définie par un début de commutation et une durée maximale de commutation depuis le début de l'opération de branchement, le début de commutation étant défini comme l'instant où la pente de la tension grille-source entre la borne de grille et la borne de source passe pour la première fois par 0 après le début de l'opération de branchement.

13. Circuit pilote selon la revendication 11, **caractérisé en ce que** la durée est définie par un début de commutation et une durée maximale de commutation depuis le début de l'opération de branchement, le début de commutation étant défini comme l'instant où la tension drain-source n'atteint plus un potentiel de seuil, le potentiel de seuil étant situé entre un potentiel maximum de service et la première tension de consigne.

14. Circuit pilote selon la revendication 11, **caractérisé en ce que** la durée est définie par un début de commutation et une durée maximale de commutation depuis le début de l'opération de branchement, le début de commutation étant défini comme l'instant où pour la première fois le courant pilote n'atteint plus une valeur de seuil après le début de l'opération de commutation, la valeur de seuil étant située entre 0V et une valeur de consigne du courant pilote.

15. Circuit pilote selon l'une des revendications 1 à 10, **caractérisé en ce que** le commutateur à semi-conducteur présente un composant IGBT.

16. Procédé de pilotage d'un circuit électronique de puissance qui présente un parcours de courant qui traverse un commutateur (1) à semi-conducteur asservi à la charge et un conducteur,
l'inductance du conducteur entraînant lors du branchement du commutateur (1) à semi-conducteur une surtension entre une première et une deuxième borne conductrice de courant du commutateur (1) à semi-conducteur,
**caractérisé en ce que**
une borne pilote du commutateur (1) à semi-conducteur est chargée ou déchargée par un courant pilote, le courant pilote étant amené par un régulateur P auquel la tension aux bornes ($U_{DS}$) entre les bornes conductrices de courant du commutateur (1) à semi-conducteur et la tension aux bornes de consigne prédéterminée ($U_{DS, soll}$) sont appliquées, est piloté de telle sorte que lors d'une opération de commutation, la tension aux bornes ($U_{DS}$) du commutateur (1) à semi-conducteur ne dépasse pas une tension aux bornes de consigne prédéterminée, ($U_{DS, soll}$).

# Fig. 1

# Fig. 2

## Fig. 3

## Fig. 4

## Fig. 5

**Fig. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5828141 A
- EP 0851584 A2
- US 6046516 A
- US 6285235 B1
- US 5475329 A